# EUROPEAN PATENT APPLICATION

(11) **EP 4 700 309 A1**
(43) Date of publication of application: **25.02.2026**
(21) Application number: 25159102.0
(22) Date of filing: 20.02.2025
(51) Int. Cl.: F25D 3/10, F25D 19/00, F28F 3/08, F28D 21/00, F25B 9/12

(54) **CRYOGENIC COOLING SYSTEM WITH HEAT EXCHANGER**

(30) Priority: 21.08.2024 GB 202412333
(71) Applicant: Oxford NanoScience Limited, Oxfordshire OX13 5QX (GB)
(72) Inventor: MATTHEWS, Anthony, Abingdon, OX13 5QX (GB)
(74) Representative: Gill Jennings & Every LLP

(57) **Abstract**

A cryogenic cooling system is provided comprising one or more heat exchangers 200 that are thermally coupled to a target assembly 11-13 and fluidly coupled to a helium refrigeration plant. Each heat exchanger 200 comprises a stack of plates 208, wherein the plates are profiled to form channels 212 between each adjacent plate, the channels 212 for conveying supercritical helium between an inlet 202 and an outlet 204 of the heat exchanger 200.

## Description

### FIELD OF THE INVENTION

The present invention relates to the field of cryogenic cooling systems. A particularly desirable use of the technology is commercial-scale cryogenic quantum computing and other bulk-cooling applications.

### BACKGROUND

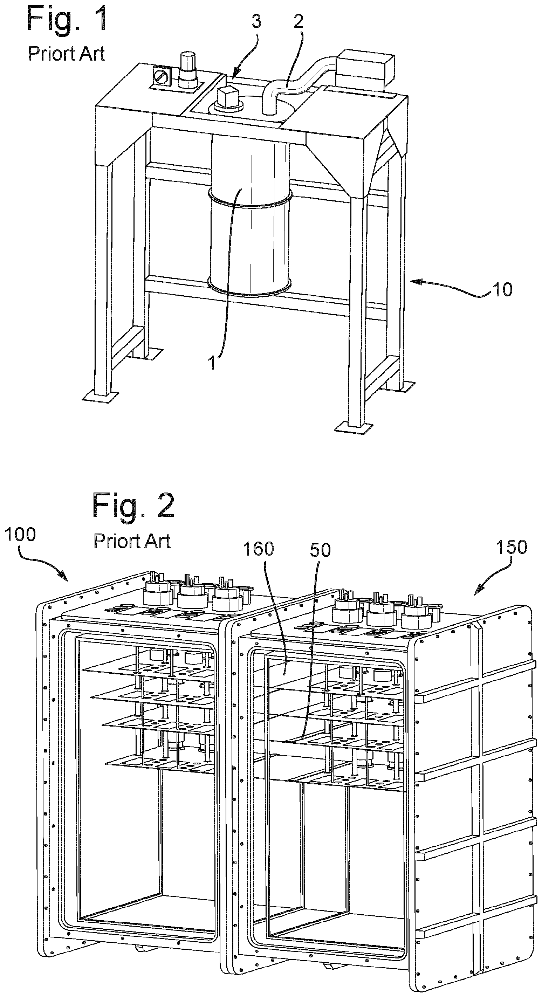

The scale-up of quantum computing, based on superconducting quantum information processing (QIP) devices, will require a continuously low temperature on the order of 10-20 mK or less for QIP device operation. For this, it is envisaged that dilution refrigerators will be essential. Today's industrial QIP companies use commercially available cryogen-free ("dry") dilution refrigerators that follow a traditional form-factor: a series of vertically spaced copper plates, with circular cross section, thermally isolated from each other, with a single dilution unit installed between the lower stage plates. Together with the pipework connected to the dilution unit inlet and outlet, and the pumping hardware, a closed cycle dilution refrigerator is created. Concentric, cylindrical radiation shields enclose each stage plate of the dilution refrigerator insert, to reduce the radiated heat load onto the dilution refrigerator stages (-0.8 K at the still stage, down to below 10 mK at the mixing chamber stage). The whole assembly is enclosed in a cylindrical vacuum vessel. The assembly is often frame-mounted to enable radiation shield and outer vacuum chamber removal. An example of a prior art dilution refrigerator, as discussed above, is shown by Figure 1. A cylindrical outer vacuum chamber 1 is supported by a cryostat support frame 10. External components of a helium gas handling system 2 and a pulse tube refrigerator 3 are also visible.

EP 4271949 B1 describes a cryogenic cooling system having a new form factor suitable for building QIP server farms. An example of a system disclosed in EP 4271949 B1 is shown by Figure 2. In contrast to Figure 1, the cryogenic cooling system is modularised. This allows the system to be scaled up by connecting the interior of a first module 100 to other similar modules 150, thereby increasing the shared internal volume and the total cooling power available. A user can build the size of their cryogenic cooling system incrementally by connecting additional modules, which addresses the concerns of the high capital expenditure associated with owning a large cryogenic cooling system. Thermally coupling stages 50 of different connected modules 100, 150 (in this case by extension plates 160) enables the cooling power of the cryogenic refrigerators to be shared across the system. A user can hence include additional heat dissipating components to their system, typically on or between different cooled stages, and balance this heat load by connecting the module to other modules (for example an nth number of times) rather than replacing the entire system with a larger one.

The 4 K cooling power in dry dilution refrigerators has been historically provided by cryocoolers, such as pulse tube refrigerators, Stirling refrigerators or Gifford-McMahon refrigerators. The demand for these systems arose precisely because they are a dry technology. This simplified the supporting infrastructure and experience required to operate the system, making the systems more usable in the academic setting. For commercial-scale systems, however, there are reliability concerns associated with relying on multiple cryocoolers. As the experiment size grows, the available cooling power at 4 K also becomes inadequate very quickly. To address this issue, EP 4271949 B1 teaches that the modular cryogenic cooling system may comprise a helium refrigeration plant that is external to the modules. Each module may comprise a first helium heat exchanger, thermally coupled to a first stage of the module, the first helium heat exchanger arranged to receive a flow of liquid helium from the helium refrigeration plant. Each module may further comprise a second helium heat exchanger, thermally coupled to a second stage of the module, the second helium heat exchanger arranged to receive a flow of gaseous helium from the helium refrigeration plant.

The invention is set in the context of improving the heat transfer between a helium refrigeration plant and a target assembly of a cryogenic cooling system, such as a thermal stage of a modularised cryogenic cooling system.

In a remote field of liquifying natural gas, it is known to use a Printed Circuit Heat Exchanger (PCHE). A PCHE is typically made by chemically etching features into a 'thin' plate of a base material. These plates can then be stacked together and diffusion bonded (at high temperature and pressure) to form one solid piece. The features etched into the surface of the plates then become an 'internal' channel structure of the heat exchanger body. Alternating layers of the PCHE may carry different fluids at different temperatures in different flow directions. The PCHE is primarily used in such applications to improve the thermal contact between different fluids. The thermal contact between the PCHE and the body to which it is mounted is almost irrelevant in such applications.

### SUMMARY OF INVENTION

A first aspect of the invention provides a cryogenic cooling system comprising: a vacuum chamber, the vacuum chamber comprising: a target assembly and a first heat exchanger assembly, the first heat exchanger assembly comprising one or more heat exchangers thermally coupled to the target assembly, wherein each said heat exchanger of the first heat exchanger assembly comprises an inlet and an outlet; a helium refrigeration plant fluidly coupled to the first heat exchanger assembly for supplying helium to the inlet of each said heat exchanger of the first heat exchanger assembly in a supercritical fluid state; wherein each said heat exchanger of the first heat exchanger assembly is configured to convey the helium from the inlet to the outlet in the supercritical fluid state; wherein each said heat exchanger of the first heat exchanger assembly comprises a stack of plates, wherein the plates are profiled to form channels between each adjacent plate, the channels for conveying the helium between the inlet and the outlet.

The system is therefore designed to enable a high heat transfer from the target assembly. For example, the plates of the first heat exchanger assembly are arranged into a stack and profiled to form channels. This provides good thermal contact between the heat exchanger body and the fluid. The helium is transmitted in a supercritical state between the inlet to the outlet of each heat exchanger, enabling it to be circulated at a high flow rate to achieve a high cooling power. This phase control of the helium can be achieved by suitable control of the temperature and pressure of the fluid supplied by helium refrigeration plant, and by arranging the first heat exchanger assembly to have a low flow impedance so there is a small pressure drop across the assembly. Each heat exchanger of the first heat exchanger assembly may also have a high bulk thermal conductivity to provide good thermal contact between the target assembly and the helium.

Each heat exchanger of the first heat exchanger assembly typically comprises a housing in which the stack of plates is arranged, wherein the housing is mounted to the target assembly. The housing may define a chamber for the heat exchanger in which the supercritical helium is conveyed. The mounting is typically a direct connection between the housing and the target assembly which facilitates good thermal contact. The connection between the housing and the target assembly will typically therefore comprise an interface of two highly thermally conductive surfaces, for example formed of copper or gold.

The thermal conductance between the housing and the target assembly scales with the contact force. High contact forces are therefore desirable. In one implementation, one or each said heat exchanger of the first heat exchanger assembly is bonded to the target assembly, for example by welding or other nonmechanical joining methods. This may create a permanent coupling between heat exchanger and the target assembly and high thermal contact. To enable different experimental setups, the target assembly may comprise a plate assembly having removable section(s), wherein the one or more heat exchangers of the first heat exchangers are bonded to the removable section(s). Each plate may form part of a thermal stage of a refrigerator assembly. The heat exchanger(s) may alternatively be bonded to other removable components of the target assembly. Alternatively, for a releasable connection, the housing may be bolted to the target assembly by one or more bolts. One or each said heat exchanger of the first heat exchanger assembly therefore may comprise a plurality of through-holes, each said through-hole extending through the stack of plates and through opposing sides of the housing. The through-holes are fluidly decoupled from the channels in the sense that they are not arranged to receive or convey the helium from the helium refrigeration plant. The through-holes may form bolting points and may be spread across the surface of the heat exchanger housing. For example, the system may further comprise one or more fastening members arranged within the through-holes and configured to increase the contact force between the housing and the target assembly.

In the scenario where through-holes are provided in the housing, the stress field applied to the housing by a fastening member, such as a screw or bolt, diminishes with the radial distance from the fastening member. One or more said through-holes is therefore preferably arranged between two or more said channels, which improves the thermal conductance between the adjacent channels and the target assembly. One or more arrays of through-holes is preferably provided, each said array comprising a plurality of through-holes which are linearly arranged in a first direction along the surface of the plates, between two or more of the channels. The channels may be profiled to convey the helium between the inlet and the outlet in the first direction. The supercritical helium typically flows into the heat exchanger chamber through the inlet in a second direction that is perpendicular to the first direction and which extends along the surface of the plates. The outlet may also be arranged to convey the supercritical helium out of the housing in the second direction.

The stack of plates may be notionally divided into different portions, each portion comprising a respective area of the plates, these areas being aligned in the direction normal to the plates. The stack of plates may comprise one or more array portions and two or more channel portions, each said array portion being arranged between two said channel portions, wherein each said array of through-holes is arranged within a respective said array portion, and wherein the channels are arranged within the channel portions. The fastening members may therefore be arranged between the channels, for example along a central region of the plates and optionally bisecting the housing, for increasing the thermal conductance between the channels and the target assembly.

To increase the effectiveness of the heat exchanger, it is generally desirable to fill as much of the available area of the plate inside the housing with the channels. However, since the helium cannot be allowed to exit the through-holes, the channels must be arranged to convey the helium around the array of through-holes, and preferably near to the through-holes. The channels may therefore be further arranged within the array portion(s) for conveying the helium along one or more subareas of the plates that are positioned between adjacent through-holes of a said array. These subareas may correspond to the gaps along the plates between adjacent through-holes of the array(s).

It is desirable to balance the flow rate across the stack of plates to be approximately equal through each channel. This can generally be achieved by providing a regular pattern of channels having the same shape and width. Special control of the channel geometry may be required however within the array portion(s) to balance the flow impedance. If the flow impedance along the array portion, for example, is significantly lower than in the array portion, this may result in an imbalance of flow which could impact the overall performance of the heat exchanger. The stack of plates may therefore comprise one or more flow balancing features arranged within each said subarea for controlling the flow of the helium across the array portion(s). The flow balancing feature(s) may be arranged within the one or more channels for disrupting the fluid flow within the array portion(s). The channels are preferably arranged so that the flow impedance across the array portion(s) is substantially equal to the flow impedance across the channel portions. This may be achieved by suitable configuration of the flow balancing features and/or channels.

The stack of plates may be arranged so that the flow impedance within the array portion(s) is higher than in the channel portions. In the extreme scenario, the plates may be patterned such that the flow impedance is infinite in the array portion(s), and the helium does not flow within the array portion(s) at all. A constant flow impedance can therefore be achieved through the channels, albeit at some reduction in the "active area" of the heat exchanger that is in direct contact with the supercritical helium.

The first heat exchanger assembly may be formed from a variety of known manufacturing techniques suitable for forming patterned thin plates, for example by chemical etching, laser cutting, electrochemical machining, stamping and embossing, micro-milling, additive manufacturing (3D printing) or diffusion bonding. Preferably, each said heat exchanger of the first heat exchanger assembly is a printed circuit heat exchanger (PCHE). Unlike the PCHE discussed in the background section above, the PCHE is preferably configured for use of a single medium (the helium refrigerant). The use of a PCHE is particularly desirable because small channels can hence be formed to increase the surface area of the plate which is in contact with the helium, resulting in effective heat exchange between the fluid and the body of the body of the heat exchanger. Larger feature sizes may otherwise require a higher volume of helium to achieve the same thermal conductance. Since helium is a limited and expensive resource, it is desirable to reduce the volume of helium required within the first heat exchanger assembly.

Each plate in the stack of plates preferably comprises an inlet region, an outlet region, and a central region arranged between the inlet region and the outlet region, wherein the channels are arranged across the central region. These regions may equally be considered as forming further "portions" of the stack in addition to those earlier described, wherein the channel portions and the array portion(s) form part of the central region. The inlet region is preferably arranged to covey the helium from the inlet to the channels, and the outlet region is preferably arranged to convey the helium from the channels to the outlet. One or both of the inlet region and the outlet region may comprise one or more apertures to convey the helium in a direction normal to the plane of the plates. Each said aperture may encircled by a material forming the respective plate. The apertures of the inlet and outlet region may therefore assist with enabling the helium to flow between the plates in the stack.

The stack of plates typically comprises a first series of plates and a second series of plates. Plates of the first series are interspersed with those of the second series, typically such that two or more plates of the first series are arranged between each said plate of the second series. The second series may comprise two or more plates but typically three or more plates. Each plate of the first series may comprise an aperture formed on the inlet region which is aligned with a said aperture formed on the inlet region of an adjacent plate of the first series to form an inlet conduit for conveying the helium along the inlet region and between respective ingress points for the channels. Each channel typically has a respective ingress point and egress point on opposing sides of the central region. The inlet conduit is formed by overlapping apertures on the inlet region of adjacent plates of the first series and may disperse the fluid received from the inlet across the stack of plates (i.e. between the plates) and along the width of the central region of each plate (i.e. along the inlet region) before its ingress to the channels through the respective ingress points. The inlet conduit may therefore fluidly couple each of the channels to the inlet.

Each plate of the first series may comprise a said aperture formed on the outlet region which is aligned with a said aperture formed on the outlet region of an adjacent plate of the first series to form an outlet conduit for conveying the helium between an egress point for the channels and along the outlet region. The outlet conduit fulfils a similar function to the inlet conduit and may be similarly arranged, albeit between the outlet and an opposing side of the central region. The outlet conduit is formed by overlapping apertures on the outlet region of adjacent plates of the first series and may convey the fluid received from the egress points of the channels across the stack of plates (i.e. between the plates) and along the width of the central region of each plate (i.e. along the outlet region) to the outlet. The outlet conduit may therefore fluidly couple each of the channels in the stack to the outlet. One or both of the inlet conduit and the outlet conduit typically substantially extends across the width of the central region, outside the central region itself.

In use, the fluid in each heat exchanger of the first heat exchanger assembly is typically at a relatively high pressure whereas the external environment surrounding the heat exchangers is typically evacuated. This pressure differential between the inside and the outside of the heat exchanger can generate a significant force to inflate the heat exchanger. To mitigate this, one or more structurally supportive features can be formed within the heat exchanger. Preferably, the inlet region of each plate of the second series comprises a plurality of apertures that overlap the inlet conduit. Preferably still, the outlet region of each plate of the second series comprises a plurality of apertures that overlap the outlet conduit. These apertures facilitate fluid flow between opposing surfaces of each plate of the second series, within the respective inlet region or outlet region. The apertures are typically smaller than the apertures formed on the plates of the first series. When included into the heat exchanger, the plate material around the apertures of each plate of the second series will act in a manner akin to a "flying buttress" to counteract the outward forces arising from the pressure differential (but in tension rather than compression).

The geometry of the apertures may be selected to control how the helium flows between the plates, for example to enhance the flow distribution across the stack, and/or to achieve the desired structural support. The shape or size of each aperture of the second series may therefore sequentially change along the respective inlet region or outlet region in which the apertures are arranged (e.g. along the second direction). The size of each aperture in plates of the second series along the inlet region typically increases with distance from the inlet. Similarly, the size of each aperture in plates of the second series along the outlet region may decrease with distance from the outlet. Additionally or alternatively, the eccentricity of the apertures may change in a stepwise manner along the inlet region of the outlet region. The buttress support formed by the material surrounding each aperture may therefore further act as a flow steering device for the supercritical helium.

The plates of the second series may be arranged to affect how the supercritical helium disperses across the stack of plates in the inlet region before being conveyed along the central region by the channels. In a particularly desirable implementation, the inlet comprises an inlet orifice extending into the heat exchanger, wherein one or more plates of the second series abut the inlet orifice, typically along an edge of the plate(s). The abutting plate(s) of the second series may therefore disrupt a flow of helium in the direction of the inlet and encourage the even distribution of the helium across the stack on its arrival to the heat exchanger chamber. Each aperture of the inlet region and the outlet region is preferably aligned along an axis of the inlet and the outlet respectively, wherein said axes extend along the plane of the plates (and preferably parallel to the aforementioned second direction).

The first heat exchanger assembly may have utility in any number of large-scale cooling applications and the target assembly may comprise a variety of possible payloads to be cooled. For example, the target assembly may comprise a magnet or assembly of magnets. In one desirable implementation, the vacuum chamber may form a spherical tokamak, in which case the target assembly may comprise one or more field coils for forming a magnetic field. In another desirable implementation, the target assembly may form part of a cryogenic refrigerator (e.g. in the context of a QIP server farm). For example, the cryogenic cooling system may further comprise a refrigerator assembly (e.g. a dilution refrigerator assembly, helium-3 or helium-4 refrigerator, adiabatic demagnetization refrigerator, sorption refrigerator or cryocooler), the refrigerator assembly comprising a plurality of thermal stages, each said thermal stage having a respective base temperature in use, wherein the target assembly comprises one or more of the thermal stages. Preferably each said thermal stage is arranged to have a respective base temperature in use of at least 1.0 K and preferably above 2.0 K. The first heat exchanger assembly may provide a viable alternative to the use of a helium-4 refrigerator "1-K pot", in some applications. The first heat exchanger assembly is preferably arranged at higher temperature stages than the still(s) of a dilution refrigerator assembly, which is generally at 500-700 mK. For example, the target assembly may comprise one or more stages having a respective base temperature at 3-5 K or any other thermal stage required depending on the application. This temperature may be achieved by operation of the first heat exchanger assembly, potentially combined with another cooling means. The first heat exchanger assembly may perform the function of pre-cooling the thermal stages and obviate the need for cryocoolers, which have reliability concerns and a limited cooling power.

Multiple thermal stages of the refrigerator assembly may be cooled by the first heat exchanger assembly. The first heat exchanger assembly preferably comprises a plurality of said heat exchangers, each said heat exchanger of the first heat exchanger assembly being mounted to a respective said thermal stage. For example, one or more heat exchangers of the first heat exchanger assembly may be bonded or releasably coupled to a removable portion of the respective thermal stage.

Two or more heat exchangers of the first heat exchanger assembly may be arranged on separate fluid circuits, each of which is fluidly coupled with the helium refrigeration plant and serve different functions. For example, the system may comprise a first fluid circuit and a second fluid circuit, wherein the first heat exchanger assembly comprises a first set of heat exchangers and a second set of heat exchangers, each said set comprising one or more said heat exchangers, wherein the first set of heat exchangers forms part of the first fluid circuit and the second set of heat exchangers forms part of the second fluid circuit. Each set may comprise one or more said heat exchangers. The first set of heat exchangers may be mounted to a first thermal stage having a first base temperature (typically between 2 and 4 K), and the second set of heat exchangers may be mounted to one or more thermal stages having a base temperature above the first base temperature. The refrigerator assembly may further comprise a condensing line for supplying helium, and the system may further comprise a second heat exchanger assembly comprising one or more heat exchangers arranged to thermally couple the condensing line to the first fluid circuit. The refrigerator assembly preferably further comprises a mixing chamber of a dilution refrigerator, the mixing chamber arranged to receive the helium from the condensing line. The first fluid circuit may therefore be used to pre-cool the incoming helium-3 that is circulated within the dilution refrigerator and the second fluid circuit may be used to pre-cool one or more higher temperature thermal stages that may be connected to respective heat radiation stages and/or electrical components of the system. For example, the second set of heat exchangers may be mounted to one or more of the following thermal stages: a second thermal stage having a base temperature above that of the first thermal stage, a third thermal stage having a base temperature above that of the second thermal stage and a fourth thermal stage having a base temperature above that of the third thermal stage. The second set of heat exchangers preferably comprises a plurality of heat exchangers of the first heat exchanger assembly, wherein a said heat exchanger of the second set is mounted to each of the second, third and fourth thermal stages.

In contrast to the heat exchanger(s) of the first heat exchanger assembly, the heat exchanger(s) of the second heat exchanger assembly may be dual-media heat exchanger(s) for thermally coupling two fluids that are fluidly disconnected from each other. The first fluid circuit and the second fluid circuit are typically arranged to convey helium-4 and wherein the condensing line is arranged to convey helium-3. The second heat exchanger assembly is therefore preferably arranged to receive a flow of supercritical helium from an outlet of a heat exchanger of the first set of heat exchangers. The second heat exchanger assembly may comprise one or more counterflow heat exchangers. The system may further comprise one or more return conduits configured to convey the helium from the first heat exchanger assembly to the helium refrigeration plant. Each said fluid circuit may therefore comprise a respective return conduit, although use of a common return conduit (at least in part) is also envisaged. The supply and return conduits may be fluidly connected to one or more cryolines of the helium refrigeration plant for conveying the supercritical helium between the vacuum chamber and a cryogenic cold box containing a reservoir of helium.

It is envisaged that the use of a helium refrigeration plant for pre-cooling one or more thermal stages of a dilution refrigerator is particularly desirable in bulk cooling applications where the use of multiple cryocoolers may be considered unreliable, ineffective at delivering the necessary cooling power and not cost effective. Such large-scale superconducting cooling may be facilitated through the use of a modular dilution refrigerator assembly. The refrigerator assembly is therefore preferably a dilution refrigerator assembly comprising a plurality of dilution refrigerators, and the system preferably further comprises a plurality of modules, each said module comprising a module housing, the module housing having a plurality of side faces, wherein two or more said modules are mutually connected at respective side faces, wherein each said dilution refrigerator is arranged within a respective said module, and wherein the connected modules form the vacuum chamber. Other refrigerator assemblies are contemplated instead of a dilution refrigerator (as discussed above) and which may form part of the modular system.

A second aspect of the invention is a quantum information processing system comprising a cryogenic cooling system according to the first aspect. This may include superconducting QIP devices below 1 K and higher temperature QIP modalities (e.g. based on electron spin, quantum dots or trapped ion qubits) not requiring the use of a dilution refrigerator. The second aspect may share any of the features discussed in connection with the first aspect.

### BRIEF DESCRIPTION OF DRAWINGS

Embodiments of the invention will now be discussed with reference to the accompanying drawings, in which:
Figure 1 is a perspective outer view of a first cryogenic refrigerator according to the prior art;
Figure 2 is a perspective cross-sectional view of a second cryogenic refrigerator according to the prior art;
Figure 3 is a perspective view of a heat exchanger for forming part of a system according to a first embodiment of the invention;
Figure 4 is a first cross-sectional view of the heat exchanger according to the first embodiment of the invention;
Figure 5 is a view of a portion of the heat exchanger according to the first embodiment of the invention;
Figure 6 is a view of a portion of a first variant of the heat exchanger;
Figure 7 is a view of a portion of a second variant of the heat exchanger;
Figure 8 is a view of a plate of a first series of plates for forming part of the heat exchanger according to the first embodiment of the invention;
Figure 9 is a view of a plate of a second series of plates for forming part of the heat exchanger according to the first embodiment of the invention;
Figure 10 is a view of a plate of a first series of plates for forming part of a third variant of the heat exchanger;
Figure 11 is a second cross-sectional view of the heat exchanger according to the first embodiment of the invention;
Figure 12 is a schematic illustration of a cross-sectional view of a fourth variant of the heat exchanger;
Figure 13 is a schematic illustration of a cross-sectional view of a fifth variant of the heat exchanger;
Figure 14 is an illustration of part of a sixth variant of the heat exchanger;
Figure 15 is a schematic illustration of a cryogenic cooling system according to the first embodiment of the invention;
Figure 16 is a schematic illustration of a cryogenic cooling system according to a second embodiment of the invention; and
Figure 17 is a perspective view of a cryogenic cooling system according to a third embodiment.

### DETAILED DESCRIPTION

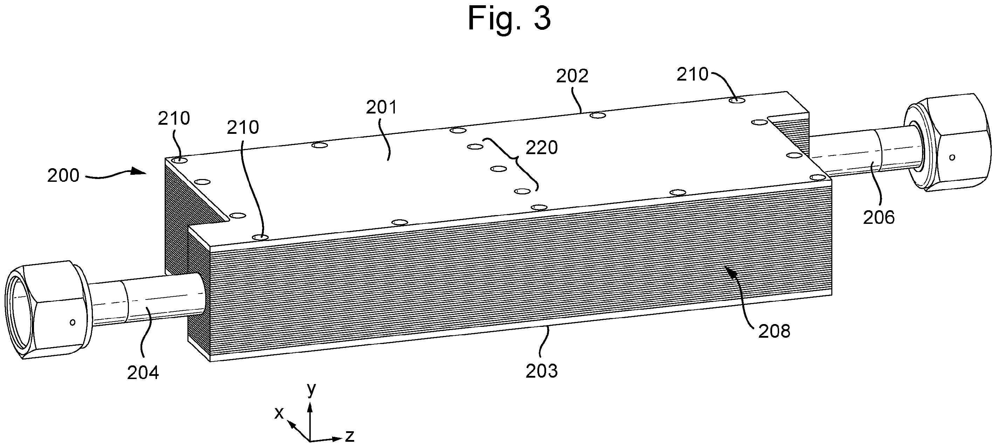

Embodiments of the invention are directed to a cryogenic cooling system in which a target assembly is cooled by helium supplied from a helium refrigeration plant to a first heat exchanger assembly in a supercritical phase. The first heat exchanger assembly comprises one or more heat exchangers that facilitate heat transfer from the target assembly to the supercritical helium. Examples of a heat exchanger for forming part of the first heat exchanger assembly will now be discussed with reference to Figures 3-14. Primed reference numerals are used to indicate similar features across different embodiments.

A first example of a printed circuit heat exchanger (PCHE) 200 forming part of a first heat exchanger assembly is shown by Figure 3. The PCHE 200 comprises a first outer plate 201, a second outer plate 203, and a stack of plates 208 arranged between the first and second outer plates 201, 203. The plates 201, 203, 208 are stacked together and diffusion bonded to form a housing 202 for the PCHE 200. The plates 201, 203, 208 are formed of a material having a high thermal conductivity at cryogenic temperatures, such as copper. Each of the plates 201, 203, 208 has the same footprint along its outer edge, and the plates 201, 203, 208 are aligned along a common axis extending through the normal of the plates 201, 203, 208, which is the y-axis illustrated in Figure 3.

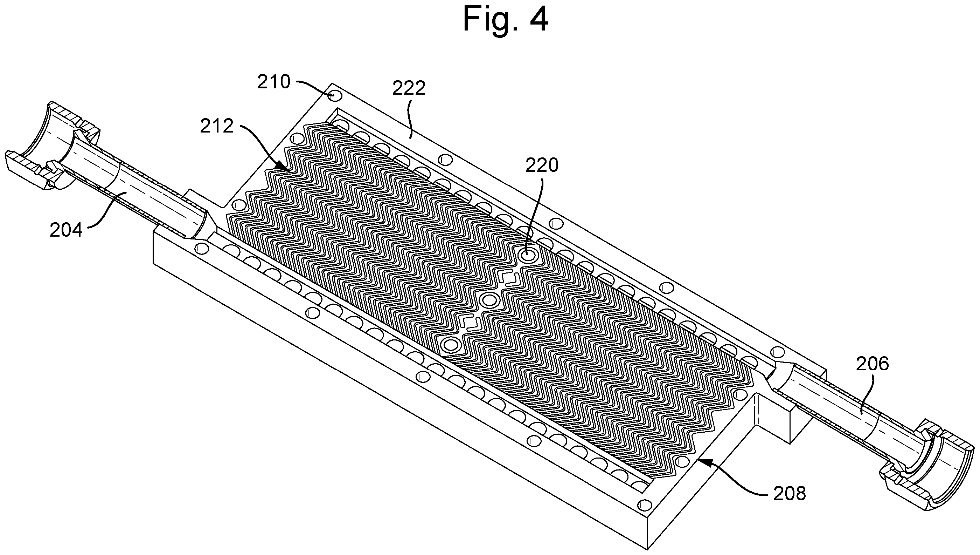

An inlet 204 conveys supercritical helium into the housing 202 and an outlet 206 conveys the supercritical helium from the housing 202. The inlet 204 and outlet 206 are arranged along a fluid circuit that is coupled to the helium refrigeration plant (not shown). A first surface of each plate from the stack of plates 208 is patterned by chemical etching to form a plurality of channels 212 extending along a central region 230a, 230b of each of the plates (see Figures 4-10), the channels 212 arranged for conveying the supercritical helium between the inlet 204 and the outlet 206. The opposing second surface of each plate in the stack 208 is typically flat and abuts the first surface of an adjacent plate in the stack 208 so that the channels 212 form an internal structure of the PCHE 200. In general, it is desirable to make the channels 212 in the PCHE 200 small to improve the heat exchange efficiency. However, small channels will have a higher impedance to fluid flow, leading to a higher pressure drop across the PCHE 200. To overcome this, many parallel channels are used and the plates are stacked so that a high channel number can fit in a compact form factor.

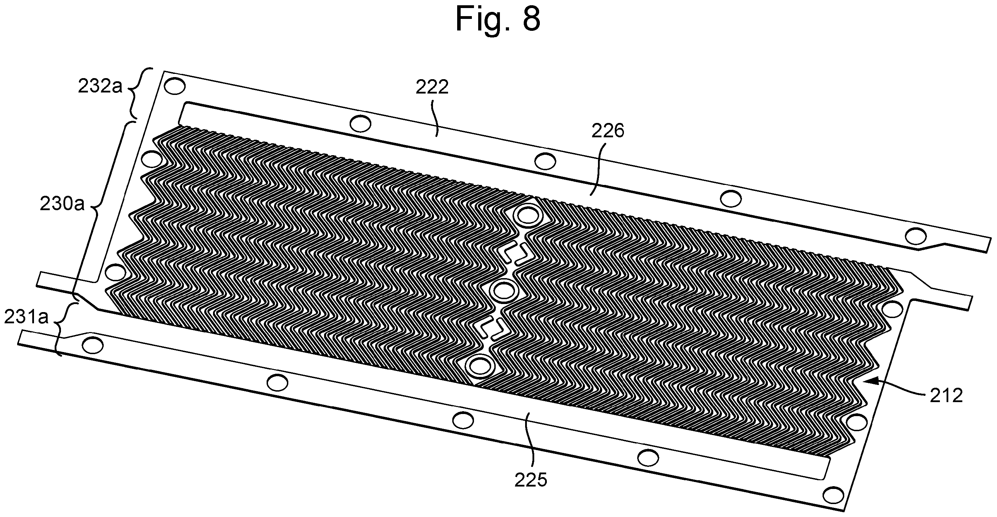

Figure 4 is a cross-sectional view of the PCHE 200 of Figure 3 taken through the XZ plane in which the plates lie, the plane extending through the housing 202. The stack of plates 208 is arranged into a first series of plates 222 and a second series of plates 224. These will be discussed in further detail in connection with Figures 8-11. The central region 230a of a plate of the first series 222 is visible in Figure 4 overlaying a plate of the second series 224. The channels 212 meander within this central region 230b to increase the surface area of the plates 208 that is in contact with the helium. The channels 212 zigzag across each plate of the stack of plates 208 to increase the contact surface area of the plates 208 that is in contact with the helium flowing in the channels 212. The same pattern is typically provided on each of the plates of the stack of plates 208. A variety of different channel patterns could however be used, including a wave pattern. The pattern will typically be chosen to extend the transit time for the helium and so increase the thermal interaction with the PCHE.

A plurality of through-holes 210, 220 extends through the PCHE 200, each through-hole 210, 220 extending along the y-axis and between opposing sides of the housing 202. Each through-hole 210, 220 is fluidly decoupled from the channels 212 and receives a respective fastening member, such as a bolt or screw, for releasably mounting the PCHE 200 to the target assembly by a high contact force. This increases the thermal conductance between the PCHE 200 and the target assembly. The stress field applied from a fastening member to the PCHE 200 decreases with the radial distance. Therefore, to maintain a high thermal conductance across the PCHE 200, multiple through-holes 210, 220 are positioned across the surface of the housing 202. The through-holes 210, 220 are arranged into a first set 210 and a second set 220. In the illustrated embodiment, the first set of through-holes 210 comprises fourteen through-holes that are arranged around the perimeter of each plate 202, 208, 208, surrounding the central region 230a, 230b. The second set of through-holes 220 comprises three through-holes which are linearly arranged in the x-axis to form an array, the array extending through the central region 230a, 230b so that the channels 212 are disposed on either side of the array. In other embodiments a plurality of said arrays may be provided within the second set, the arrays being displaced from each other along the z-axis and typically parallel to each other along the x-axis. Any number of through-holes may be provided within each array.

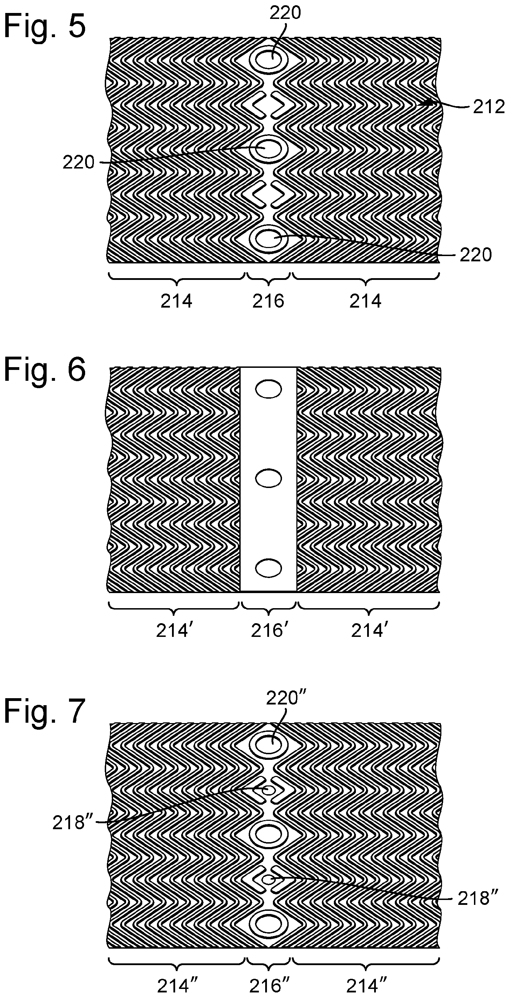

The second set of through-holes 220 advantageously enable higher heat conductance between the central region 230a, 230b of the PCHE 200 and the target assembly. However, consideration should also be given to how the presence of the through-holes of the second set within the central region 230a, 230b of the plates might affect the flow characteristics of the helium. Different arrangements are shown in each of Figures 5, 6 and 7, which show part of a central region of a plate of the first series, comprising an array portion in which an array of through-holes of the second set is arranged, the array portion being positioned between two channel portions comprising the channels. In the embodiment of Figure 5, the pattern formed by the channels 212 has reflective symmetry along the array, thus enabling the channels 212 to be brought into proximity with the through-holes of the second set 220. The width of the channels 212 is constant across the channel portions 214, however the geometry of the channel patterns is such that the channel width is larger within the array portion 216. The distance between adjacent channel walls increases in the subareas of the plate arranged between adjacent through-holes of the array. Consequently, the flow impedance along the array portion 216 tends to be lower than that of the channel portions 214. This can lead to an imbalance in the flow rate across the PCHE 200 which may impact its overall performance.

Figure 6 is a first alternative to the arrangement shown in Figure 5. In this example the array portion 216' is profiled to prevent any fluid flow within the array portion 216' and between adjacent through-holes of the array. The channels 212' extend along the channel portions 214' only and not along the array portion 216'. Each channel 212' therefore has a constant width, and so the flow imbalance discussed above in connection with Figure 5 does not arise. However, this solution comes at the expense of a reduction in the active area of the heat exchanger, which could also impact the performance of the heat exchanger.

Figure 7 is a second alternative to the arrangement shown in Figure 5, overcoming the problems discussed in connection with Figures 5 and 6. This embodiment differs from that of Figure 5 in that flow balancing features 218" are formed along the surface of the plates in each subarea of the array portion 216" extending between adjacent through-holes of the second set 220". The flow balancing features 218" are arranged to control the effective flow impedance (related to the channel width) within the array portion 216" to be substantially same as in the channel portions 214". This flow balancing features 218" may therefore balance (or "match") the flow impedance between the channel portions 214" and the array portion 216", without reducing the active area of the heat exchanger. The size, shape and position of the flow balancing features 218" could be selected depending on the desired impedance matching with respect to the adjacent channels. In this instance, the flow balancing features 218" are circular features arranged along the line of reflective symmetry earlier discussed and created by the same etching process which forms the channels 212".

In a further embodiment (not illustrated) the PCHE is bonded to a target assembly, such as a removable part of a cryogenic cooling system. This alternative method of securement can prevent ballooning at the joint, improve the thermal contact and obviates the problems discussed in connection with Figures 5 and 6, since the through-holes 210, 220 can then be omitted (which simplifies the design). The active area of the heat exchanger may also therefore be larger than in the Figure 7 embodiment. The appropriate means for connecting the heat PCHE to the target assembly can be selected depending on the application.

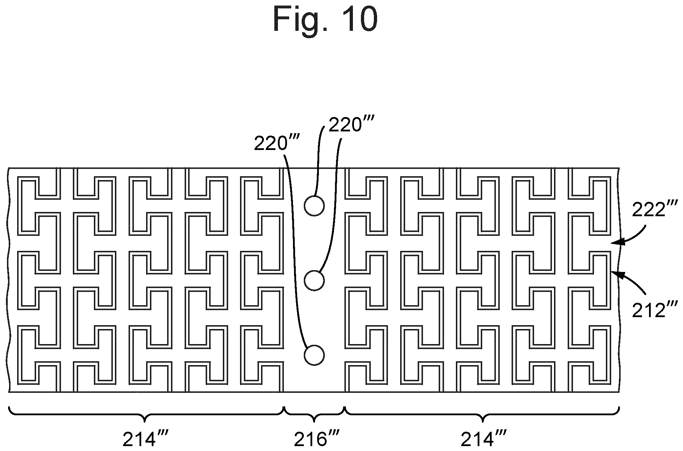

Figure 10 depicts a portion of a plate of the first series 222‴ in another embodiment, the plate 222‴ having an alternative flow channel design. Similar to Figure 6, the array portion 216‴ is profiled to prevent any fluid flow within the array portion 216‴ and between adjacent through-holes 220‴ of the array. The channels 212‴ extend along the channel portions 214‴ only and not along the array portion 216'". Each channel 212‴ has a constant width but is arranged in a different pattern from the previous embodiments. In Figure 10, the channels 212‴ follow a meandering path that forms a grid-like structure. Each channel 212‴ thereby has a relatively high contact area along the plate 222‴ which can lead to effective heat exchange in low cooling power applications. However, a limitation of the flow channel design is that relatively few channels can fit onto a given surface area of the plate 222'". This can lead to a higher pressure drop across the central region which can limit the potential applications for the PCHE (since there is a need to control the enthalpy difference across the system, as will be explained), and increase the amount of work which helium refrigeration plant need to do to re-supply back to the fluid circuit.

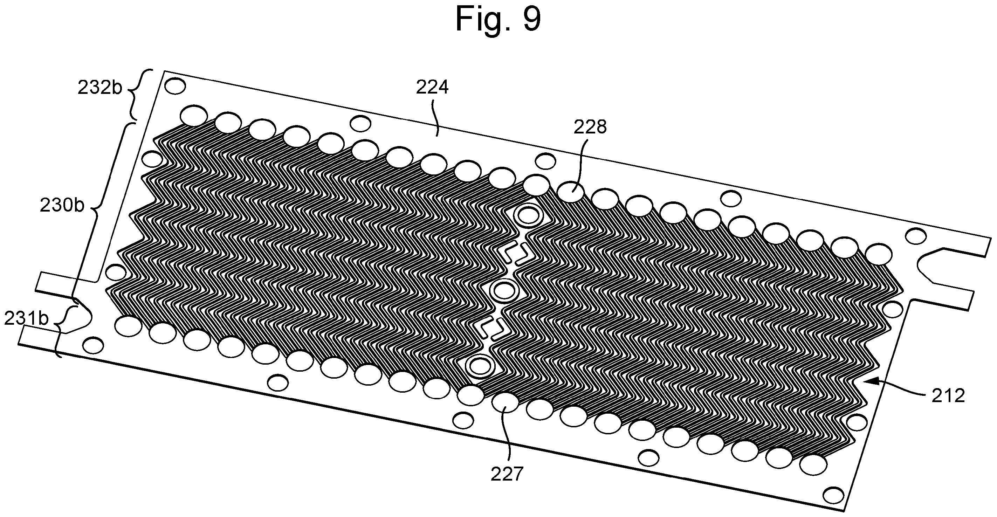

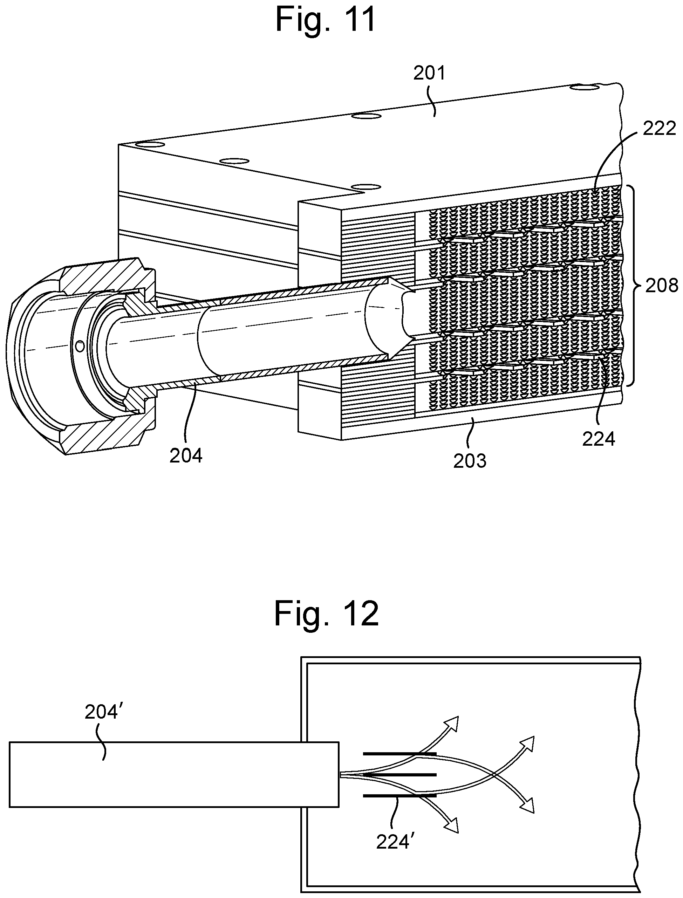

Returning to the embodiment of Figures 3-5, 8-9 and 11, a plurality of plates of the first series 222 is arranged between each adjacent plate of the second series 224. Figure 8 shows an example of a plate of the first series 222 and Figure 9 shows an example of a plate of the second series 224. Figure 11 is a cross-sectional image in the YZ plane extending through the inlet 204 and showing the layered arrangement of the plates of the first and second series 222, 224. The stack of plates 208 comprises four plates of the second series 224 and a plurality of plates of the first series 222 arranged between each adjacent plate of the second series 224. Each plate of the stack 208 has central region 230a, 230b that is arranged between an inlet region 231a, 231b of the plate and an outlet region 232a, 232b of the plate.

The inlet region 231a, 231b is arranged to convey the helium from the inlet 204 to the channels 212 and the outlet region 232a, 232b is arranged to convey the helium from the channels 212 to the outlet 206. The inlet region 231a of the plates of the first series 222 comprises a large aperture extending along the length of the central region 230a. When the plates of the first series 222 are stacked together, the aperture forms a chamber referred to as an inlet conduit 225. The inlet conduit 225 enables the helium to flow across the stack 208 between the plates of the first series 222 (in the y-direction) and across the central region 230a (in the z-direction), along the inlet region 231a. The inlet conduit 225 may fluidly couple the ingress point for each channel 212 on the plate of the first series 222 with the inlet 204. Similarly, the outlet region 232a of the plates of the first series 222 comprises a large aperture extending along the length of the central region 230a which forms another chamber referred to as an outlet conduit 226. The outlet conduit 226 enables the helium to flow across the stack 208 between the plates of the first series 222 (in the y-direction) and across the central region 230a (in the z-direction), along the outlet region 231b. The outlet conduit may fluidly couple the egress point for each channel 212 on the plate of the first series 222 with the outlet 206. The inlet conduit 231a and the outlet conduit 226 are co-terminus with the inlet 204 and the outlet 206 respectively.

In contrast to the plates of the first series 222, the inlet region 231b and the outlet region 232b of the plates of the second series 224 comprise a plurality of smaller apertures 227, 228, each of which is encircled by the material forming the plate. A first plurality of apertures 227 is disposed across the inlet region 231b and a second plurality of apertures is disposed across the outlet region 232b of each plate of the second series 224, facilitating fluid flow between opposing surfaces of the plates of the second series 224 (in the y-direction). The first plurality of apertures 227 and the second plurality of apertures 228 are aligned along an axis of the inlet and the outlet respectively, wherein said axes extend along the plane of the plates in the z-direction. Each of the channels 212 on the plates of the second series 224 has an ingress point at an aperture of the first plurality of apertures 227 and an egress point at an aperture of the second plurality of apertures 228. The plate material around these apertures 227, 228 will act in a manner akin to a "flying buttress" to provide support that will counteract the outward forces arising from a pressure differential between the inside and the outside of the PCHE 200.

In addition to providing additional support to the PCHE 200, the second series of plates 224 may positioned to affect how the helium flows across the stack 208 on its arrival into the chamber and exit from the chamber. As shown by Figure 11, the inlet 204 conduit is arranged between adjacent plates of the second series 224. The inlet 204 therefore abuts plates of the first series 222 and not any of the plates of the second series 224. Figure 12 schematically depicts an alternative to the arrangement shown in Figure 11, Figure 12 being a cross-sectional view along the YZ plane and through the inlet 204'. For simplicity, the plates of the first series are not shown in Figure 12 and only a portion of the PCHE is depicted. In the embodiment of Figure 12, an edge of the inlet region of a plurality of plates of the second series 224' abuts the inlet 204'. The plates of the second series 224' are therefore arranged to spread the flow of the fluid outward, along the YZ plane, as indicated by the flow arrows in Figure 12. This encourages even distribution of the helium across the stack 208, which balances the flow rates across the surface of each plate through the channels and ultimately improves the performance of the PCHE.

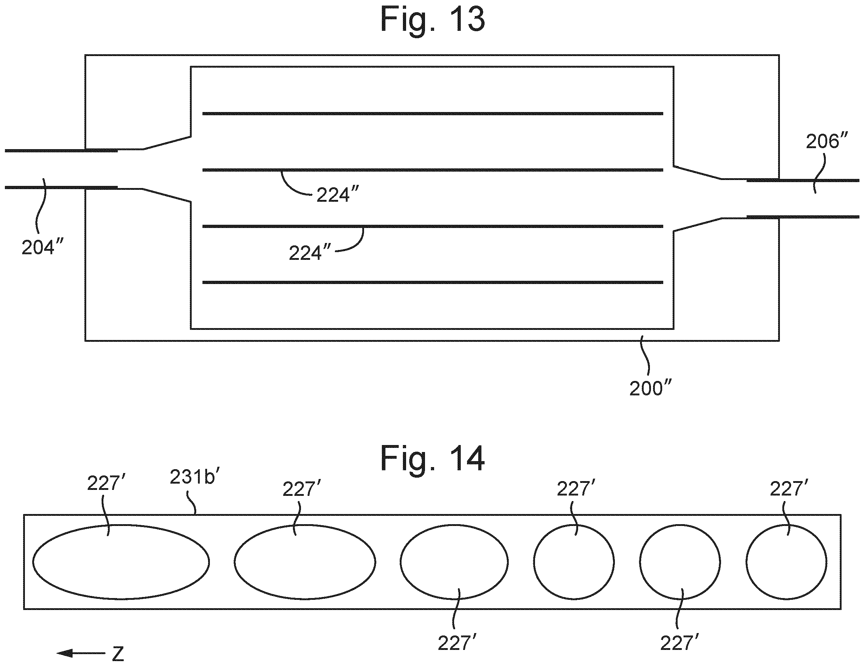

The entry and exit point for the helium within the stack of plates 208 can be selected depending on the exact position in which the inlet and outlet are brought into the PCHE, and the exact features machined into this fitting. Figure 13 is a schematical cross-sectional view of a PCHE 200" in another embodiment, the view taken through the YZ plane and showing the arrangement of the plates of the second series 224" with respect to the inlet 204" and the outlet 206". The plates of the first series are arranged between adjacent plates of the second series 224" (as before) but are not shown for clarity. In this embodiment, a plate of the second series 224" is arranged along the axis of the inlet 204", whereas the axis of the outlet 206" is arranged between adjacent plates of the second series 224".

Figure 14 illustrates part of an inlet region 231b' of a plate of the second series in a further embodiment. In this embodiment, the first plurality of apertures 227' in the inlet region 231b' are again aligned with the axis of the inlet, which is in the z-direction. The fluid therefore flows from the inlet and along the plate substantially in the z-direction. The geometry of the apertures 227' of the inlet region 231b' sequentially changes along the axis of the inlet, which is aligned with the z-axis, to further control the flow or mixing of the helium arriving from the inlet. The fluid pressure will notionally be highest proximal to the inlet. To assist with driving the fluid flow along the y-axis, the size of the apertures 227' increases with distance from the inlet. In this embodiment, the apertures 227' proximal to the inlet are circular and the eccentricity of the apertures 227' then progressively increases along the inlet region. Other shaped apertures are also envisaged depending on the desired flow characteristics between the plates. Matching shaped apertures may be provided on the corresponding outlet region of each plate of the second series so that the shape and size of the apertures are the same on both sides of each channel.

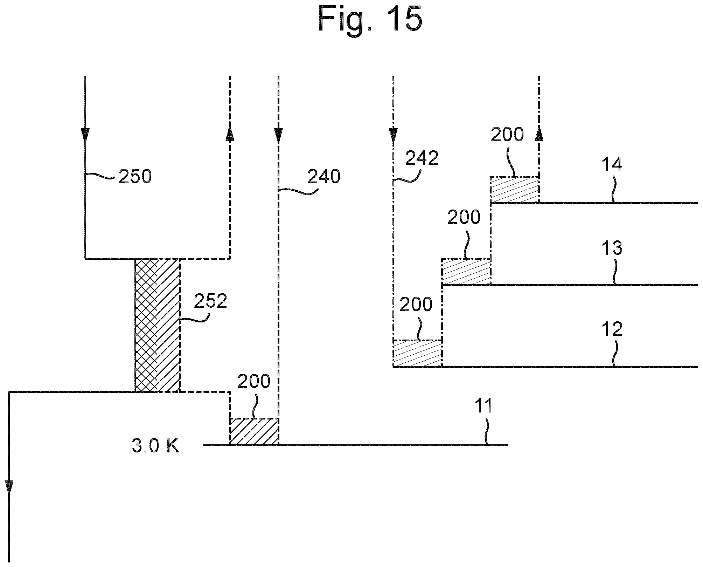

Figure 15 is a schematic view of a portion of a cryogenic cooling system according to a first embodiment. The system comprises a tiered assembly of thermal stages 11-14 that is housed within a vacuum chamber (not shown). A combination of the gas gap heat switches, heat pipes and low thermal conductivity support rods connected to the housing of the vacuum chamber holds the stages 11-14 in the tiered arrangement shown. Each thermal stage 11-14 comprises a flange of highly thermally conductive material, such as copper, which is cooled to a respective base temperature in operation of the system by a refrigerator assembly (not shown). The stages 11-14 may support electrical elements, for example forming part of a quantum information processing (QIP) system, which may provide a heat load on the system. Each thermal stage is connected to a respective heat radiation shield (not shown), each said heat radiation shield surrounding the lower temperature components of the system. Exemplary aspects of the system are discussed in further detail in EP 4271949 B1.

The stages 11-14 form a target assembly that is configured to be cooled by a first heat exchanger assembly. The first heat exchanger assembly comprises a first circuit 240 and a second circuit 242, wherein each of the first and second circuits 240, 242 is fluidly coupled to a helium refrigeration plant (not shown) and comprises one or more PCHE 200 configured to receive a flow of supercritical helium-4 from the helium refrigeration plant. The helium-4 is typically continuously flowed through the first heat exchanger assembly during operation of the system. The helium refrigeration plant is typically outside the vacuum chamber and further configured to receive a return flow of helium from the PCHE 200. Each of the first and second fluid circuits 240, 242 may therefore comprise a supply conduit to transmit the helium from the helium refrigeration plant into the vacuum chamber and to the first heat exchanger assembly and a return conduit to transmit the helium back from the first heat exchanger assembly to the helium refrigeration plant. The arrowheads in Figure 15 indicate the direction of fluid flow along each conduit.

The helium refrigeration plant is typically a considerable piece of infrastructure which may be at least partially installed outside of a building, for example as is the case at ITER in Cadarache, France. The plant typically comprises a cold box which is responsible for delivery of the supercritical helium to the cryogenic cooling system by a fluid control system comprising vacuum insulated tubes (often referred to as "cryolines") containing the supply and return flow lines for the various fluid flow circuits. The plant may further comprise a compressor system, heat exchangers and expanders, a purification system, storage and distribution infrastructure, a control system, a helium recovery system, and safety mechanisms. These components work together to compress, cool, purify, store, and distribute helium efficiently and safely. Suitable helium refrigeration plants are provided by Air Liquide, for example. As noted above, the plant is typically outside the vacuum chamber containing the first heat exchanger assembly, although it may comprise one or more additional vacuum chambers, such as dewars for containing cryogens and evacuated tubes.

The innermost stages of the system have the highest radiative shielding and so can obtain a lower base temperature during steady state operation of the system. The first stage 11 is the lowermost stage shown and is configured to be cooled to a base temperature of 2-3 K. The second stage 12 is arranged between the first thermal stage 11 and a third thermal stage, and configured to be cooled to a base temperature of above that of the first stage 11. The third thermal stage 13 is arranged between the second thermal stage 12 a fourth thermal stage, and configured to be cooled to a base temperature above that of the second stage 12. The fourth thermal stage 14 is the outermost stage shown and is configured to be cooled to a base temperature above that of the third stage. The fourth thermal stage 14 may therefore be at a relatively high temperature within the system, e.g. 100-150 K. The exact number and target temperatures of the thermal stages 11-14 is configurable based on the end user requirements. One can choose as many or as few intermediate thermal stages as desired consistent with the maximum cooling capacity that would be available at each stage. Each thermal stage 11-14 is conductively cooled by a respective PCHE 200 that is mounted to the stage, the PCHE forming part of the first circuit 240 or the second circuit 242. Additional lower temperature thermal stages are components typically provided, such as may be needed for operation of a dilution refrigerator. The incorporation of the PCHE 200 on the first stage 11 may effectively replace the need for a helium-4 refrigerator, or "1-K pot", in some applications.

The enthalpy difference for the helium across each circuit 240, 242 is controlled to maintain the fluid in a supercritical phase. This is determined from the temperature and pressure of the fluid at the start and end of each circuit 240, 242, and will be driven by the take up of heat from the system (at a given fluid flow rate). The helium-4 remains supercritical provided the final return pressure from the last PCHE in the series is above the critical pressure. The helium refrigeration plant is hence designed according to the predicted heat load requirements to provide the required inlet temperature, pressure and flow to keep the helium in a supercritical phase throughout each circuit 240, 242. For precise temperature control, additional heaters could be used to maintain the parts of the target assembly at a given temperature regardless of the experimental heat load.

The PCHE 200 which are mounted to each of the thermal stages 11-14 form a first heat exchanger assembly. The first heat exchanger assembly may then be notionally divided into a first set of heat exchangers and a second set of heat exchangers. The first set of heat exchangers forms part of the first circuit 240 and the second set of heat exchangers forms part of the second circuit 242. The first set therefore comprises the one or more PCHE mounted to the first thermal stage 11, whereas the second set comprises the one or more PCHE mounted to each of the higher temperature thermal stages 12-14. Each of the PCHE 200 will operate at a slightly different temperature as the outlet of one becomes the inlet to the next along the respective circuit.

The cryogenic cooling system may comprise any (or a combination) of a pumped helium-4 system, a pumped helium-3 system, or a dilution refrigerator assembly. A dilution refrigerator assembly may comprise one or more dilution refrigerators for cooling a sample to temperatures below 50 mK at a mixing chamber stage (not shown). The dilution refrigerator assembly comprises a condensing line 250 for supplying helium-3 to one or more mixing chambers (not shown) of the dilution refrigerator assembly. The system further comprises a second heat exchanger assembly comprising a dual-media heat exchanger 252, typically a counterflow heat exchanger, arranged to thermally couple the condensing line 250 to a return conduit of the first circuit 240. The helium-3 from the condensing line 250 may flow through the dual-media heat exchanger 252, where it is cooled by the helium-4 in the first circuit 240 that has exited from the PCHE 200 on the first thermal stage 11. This process assists with pre-cooling the helium-3 before it enters the mixing chamber, which is required for operation of the dilution refrigerator. In prior art systems the helium-3 for a dilution refrigerator is instead precooled using different stages of a pulse tube refrigerator (PTR). Such PTRs may be avoided in the present embodiment by instead incorporating the dual-media heat exchanger 252, which is a particularly efficient solution. The first circuit 240 then returns the supercritical helium-4 from the dual-media heat exchanger 252 to the helium refrigeration plant. The second circuit 242 is does not overlap the first circuit 240 and supplies a flow of supercritical helium-4 to PCHE 200 on each of the second, third and fourth thermal stages 12-14 in sequence.

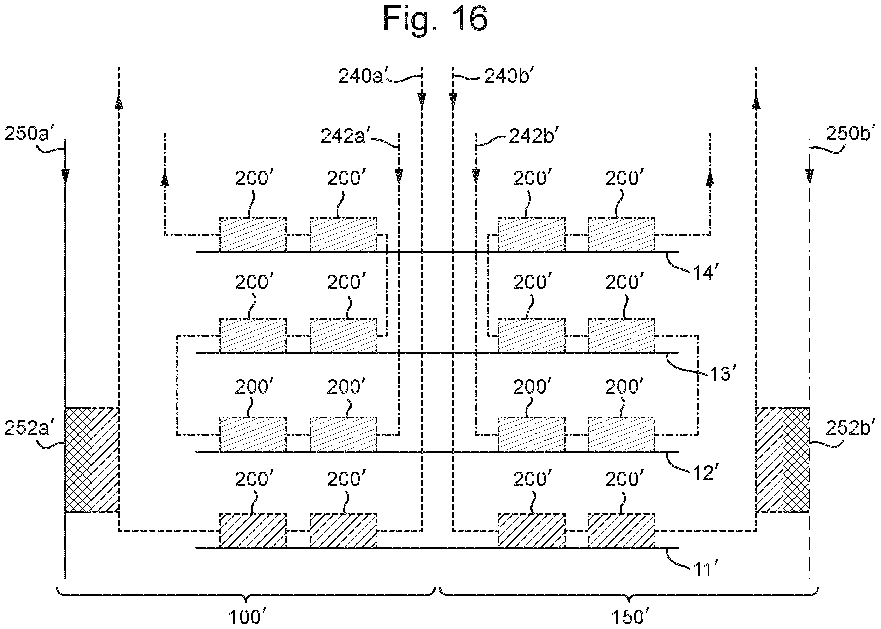

Figure 16 is a schematic view of a portion of a cryogenic cooling system according to a second embodiment. The system comprises is a modular cryogenic cooling system comprising a first module 100' connected to a second module 150'. Each module 100', 150' has a module housing forming part of a vacuum chamber for the system, the module housing having four side faces, wherein the modules 100', 150' are mutually connected at respective side faces. A plurality of thermal stages is arranged within each module housing wherein co-planar stages are connected together by a stage extension plate to form a common thermal stage for the system (similar to the Figure 2 discussion above). The system therefore comprises a first thermal stage 11', a second thermal stage 12', a third thermal stage 13' and a fourth thermal stage 14', having the tiered arrangement and respective base temperatures discussed in the embodiment of Figure 15.

Four PCHE 200' are provided on each of the thermal stage 11'-14' of the system. Each module 100', 150' is connected to the helium refrigeration plant to convey supercritical helium-4 through respective fluid circuits, as discussed for Figure 15. The first circuit 240a', provided within the first module 100', conveys helium-4 from the helium refrigeration plant to two PCHE 200' positioned on the first thermal stage 11', within the first module 100', which form a "first set of heat exchangers" in this embodiment. A return conduit of the first circuit 240a' then thermally couples the outgoing helium-4 to incoming helium-3 in a first condensing line 250a' in the first module 100' by a first dual-media heat exchanger 252a'. The helium-4 is then returned to the helium refrigeration plant along the first circuit 240a'. The second circuit 242a', provided within the first module 100', sequentially conveys helium-4 from the helium refrigeration plant to two PCHE 200' positioned on each of the second, third and fourth thermal stages 12'-14', within the first module 100', which form a "second set of heat exchangers" in this embodiment. The helium-4 is then returned to the helium refrigeration plant along the second circuit 242a'.

Similarly, a third fluid circuit 240b', provided in the second module 150', conveys helium-4 from the helium refrigeration plant to two PCHE 200' positioned on the first thermal stage 11', within the second module 150'. A return conduit of the third fluid circuit 240b' then thermally couples the outgoing helium-4 to incoming helium-3 in a second condensing line 250b' in the second module 150' by a second dual-media heat exchanger 252b'. The helium-4 is then returned to the helium refrigeration plant along the third fluid circuit 240b'. A fourth fluid circuit 242b', provided within the second module 150', sequentially conveys helium-4 from the helium refrigeration plant to two PCHE 200' positioned on each of the second, third and fourth thermal stages 12'-14', within the second module 150'. The helium-4 is then returned to the helium refrigeration plant along the fourth fluid circuit 242b'.

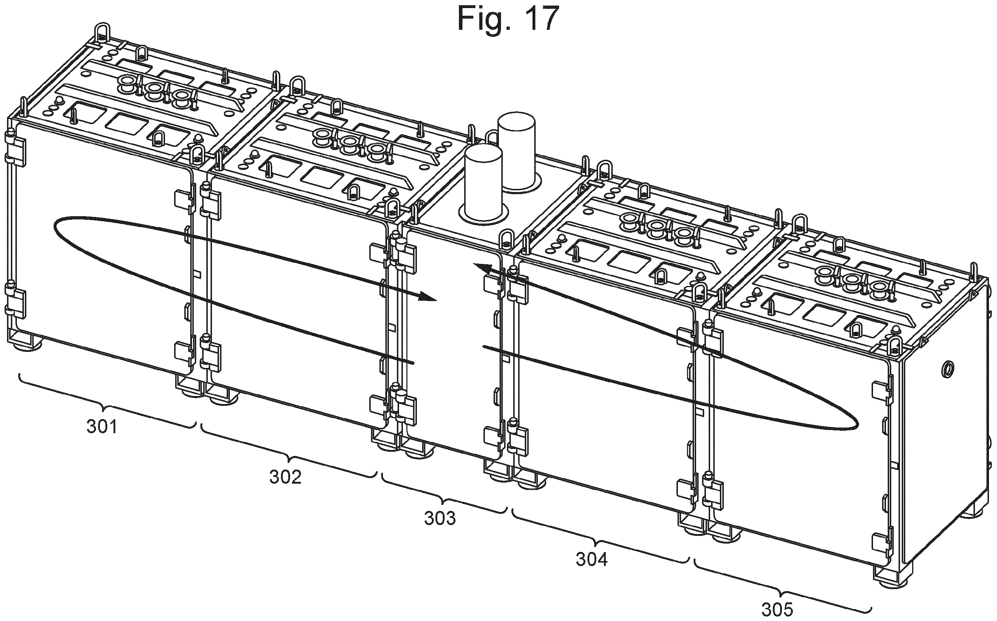

Figure 17 illustrates an alternative arrangement for a modular cryogenic cooling system in a third embodiment. This embodiment comprises a linear array of five connected modules: a first module 301, a second module 302, a third module 303, a fourth module 304 and a fifth module 305. Each module is connected to an adjacent module by a side face of the module housing to form a common vacuum chamber comprising the internal volume for each of the modules. The second module 302 is connected between the first module 301 and the third module 303, the third module 303 is connected between the second module 302 and the fourth module 304. and the fourth module 304 is connected between the third module 303 and the fifth module 305.

Each of the first, second, fourth and fifth modules 301, 302, 304, 305 may comprise thermal stages forming part of a target assembly to be cooled, as discussed in the previous examples, and may further comprise one or more dilution refrigerators (as an example). In this example, the third module 303 forms a section of the vacuum chamber that connects to the cryolines of the helium refrigeration plant by two ports provided on its upper surface. The third module 303 provides a space for making the relevant fluid connections to the fluid circuits along which the heat exchangers are arranged. The third module 303 may therefore be referred to as a "cooling connection module". The first and second modules 301, 302 are thereby fluidly connected to the helium refrigeration plant by a common first fluid circuit, for supplying supercritical helium-4 to one or more shared thermal stages of the first and second modules 301, 302. The fourth and fifth modules 304, 305 are fluidly connected to the helium refrigeration plant by a common second fluid circuit, for supplying supercritical helium-4 to one or more shared thermal stages of the third and fourth modules 303, 304. The fluid flow thought the first fluid circuit is schematically represented by the curved arrow extending between the first and second modules 301, 302, and the fluid flow through the second fluid circuit is schematically represented by the curved arrow extending between the fourth and fifth modules 304, 305.

It will be appreciated that the arrangement shown in Figure 17 is purely exemplary and the cooling connection module 303 could appear in different locations within the array and relative to the remaining modules.

The systems proposed herein may have applicability in a variety of applications, but particularly in bulk-cooling applications where a high cooling power is required and there are reliability concerns associated with operating multiple cryocoolers. For example, it is envisaged that the cryogenic cooling system may be useful for building large-scale QIP server farms or cooling magnet arrays. The first heat exchanger assembly configuration enables a high heat transfer between the helium refrigeration plant and the target assembly to mitigate for potential heat loads place on the system and assist with the pre-cooling process.

Further embodiments of the invention are set out in the following numbered clauses, in which:
Numbered clause 1: A cryogenic cooling system comprising:
   a vacuum chamber, the vacuum chamber comprising: a target assembly and a first heat exchanger assembly, the first heat exchanger assembly comprising one or more heat exchangers thermally coupled to the target assembly, wherein each said heat exchanger of the first heat exchanger assembly comprises an inlet and an outlet;
   a helium refrigeration plant fluidly coupled to the first heat exchanger assembly for supplying helium to the inlet of each said heat exchanger of the first heat exchanger assembly in a supercritical fluid state;
   wherein each said heat exchanger of the first heat exchanger assembly is configured to convey the helium from the inlet to the outlet in the supercritical fluid state;
   wherein each said heat exchanger of the first heat exchanger assembly comprises a stack of plates, wherein the plates are profiled to form channels between each adjacent plate, the channels for conveying the helium between the inlet and the outlet.
Numbered clause 2: A cryogenic cooling system according to clause 1, wherein each said heat exchanger of the first heat exchanger assembly comprises a housing in which the stack of plates is arranged, wherein the housing is mounted to the target assembly.
Numbered clause 3: A cryogenic cooling system according to clause 2, wherein each said heat exchanger of the first heat exchanger assembly comprises a plurality of through-holes, each said through-hole extending through the stack of plates and through opposing sides of the housing, wherein each said through-hole is fluidly decoupled from the channels and configured to receive a respective fastening member.
Numbered clause 4: A cryogenic cooling system according to clause 3, further comprising one or more said fastening members arranged within the through-holes and configured to increase the contact force between the housing and the target assembly.
Numbered clause 5: A cryogenic cooling system according to clauses 3 or 4, wherein one or more of the through-holes is arranged between two or more said channels.
Numbered clause 6: A cryogenic cooling system according to any of clauses 3 to 5, wherein the through-holes comprise one or more arrays of through-holes, each said array comprising a plurality of said through-holes which are linearly arranged in a first direction along the surface of the plates.
Numbered clause 7: A cryogenic cooling system according to clause 6, wherein the channels are profiled to convey the helium between the inlet and the outlet in the first direction.
Numbered clause 8: A cryogenic cooling system according to clauses 6 or 7, wherein the stack of plates comprises one or more array portions and two or more channel portions, each said array portion being arranged between two said channel portions, wherein each said array of through-holes is arranged within a respective said array portion, and wherein the channels are arranged within the channel portions.
Numbered clause 9: A cryogenic cooling system according to clause 8, wherein the channels are further arranged within the array portion(s) for conveying the helium along one or more subareas of the plates that are positioned between adjacent through-holes of a said array.
Numbered clause 10: A cryogenic cooling system according to clause 9, wherein the stack of plates comprises one or more flow balancing features arranged within each said subarea for controlling the flow of the helium across the array portion(s).
Numbered clause 11: A cryogenic cooling system according to clauses 9 or 10, wherein channels are arranged so that the flow impedance across the array portion(s) is substantially equal to the flow impedance of the flow across the channel portions.
Numbered clause 12: A cryogenic cooling system according to any of the preceding clauses wherein each said heat exchanger of the first heat exchanger assembly is a printed circuit heat exchanger.
Numbered clause 13: A cryogenic cooling system according to any of the preceding clauses, wherein each plate in the stack of plates comprises an inlet region, an outlet region, and a central region arranged between the inlet region and the outlet region, wherein the channels are arranged across the central region, wherein the inlet region is arranged to covey the helium from the inlet to the channels, and wherein the outlet region is arranged to convey the helium from the channels to the outlet, wherein the inlet region and the outlet region each comprise one or more apertures to convey the helium in a direction normal to the plane of the plates.
Numbered clause 14: A cryogenic cooling system according to clause 13, wherein the stack of plates comprises a first series of plates and a second series of plates, wherein two or more plates of the first series are arranged between each said plate of the second series, wherein a said aperture formed on the inlet region of each plate of the first series is aligned with a said aperture formed on the inlet region of an adjacent plate of the first series to form an inlet conduit for conveying the helium along the inlet region and to respective ingress points for each of a plurality of the channels.
Numbered clause 15: A cryogenic cooling system according to clause 14, wherein the plates of the first series are further arranged so that a said aperture formed on the outlet region of each plate of the first series is aligned with a said aperture formed on the outlet region of an adjacent plate of the first series to form an outlet conduit for conveying the helium from respective egress points for each of a plurality of the channels and along the outlet region.
Numbered clause 16: A cryogenic cooling system according to clause 15, wherein the inlet conduit and the outlet conduit extend substantially along the width of the central region.
Numbered clause 17: A cryogenic cooling system according to clauses 15 or 16, wherein the inlet region of each plate of the second series comprises a plurality of apertures that overlap the inlet conduit, and wherein the outlet region of each plate of the second series comprises a plurality of apertures that overlap the outlet conduit.
Numbered clause 18: A cryogenic cooling system according to clause 17, wherein the shape or size of each aperture of the second series sequentially changes along the respective inlet region (231b') and outlet region in which the apertures are arranged.
Numbered clause 19: A cryogenic cooling system according to any of clauses 14 to 18, wherein the inlet comprises an inlet orifice extending into the heat exchanger, wherein one or more plates of the second series abut the inlet orifice.
Numbered clause 20: A cryogenic cooling system according to any of clauses 13 to 19, wherein each aperture of the inlet region and the outlet region is aligned along an axis of the inlet and the outlet respectively, wherein said axes extend along the plane of the plates.
Numbered clause 21: A cryogenic cooling system according to any of the preceding clauses, further comprising a refrigerator assembly, the refrigerator assembly comprising a plurality of thermal stages, each said thermal stage having a respective base temperature in use that is above 2.0 K, wherein the target assembly comprises one or more of the thermal stages.
Numbered clause 22: A cryogenic cooling system according to clause 21, wherein the first heat exchanger assembly comprises a plurality of said heat exchangers, each said heat exchanger of the first heat exchanger assembly being mounted to a respective said thermal stage.
Numbered clause 23: A cryogenic cooling system according to clause 22, wherein each said heat exchanger of the first heat exchanger assembly is bonded to a removable portion of the respective thermal stage.
Numbered clause 24: A cryogenic cooling system according to clauses 22 or 23, further comprising a first fluid circuit and a second fluid circuit, wherein the first heat exchanger assembly comprises a first set of heat exchangers and a second set of heat exchangers, each said set comprising one or more said heat exchangers, wherein the first set of heat exchangers forms part of the first fluid circuit and the second set of heat exchangers forms part of the second fluid circuit, wherein the first set of heat exchangers is mounted to a first thermal stage having a base temperature between 2 and 4 K, and wherein the second set of heat exchangers is mounted to one or more thermal stages having a base temperature above that of the first thermal stage, wherein the refrigerator assembly further comprises a condensing line for supplying helium, the system further comprising a second heat exchanger assembly comprising one or more heat exchangers arranged to thermally couple the condensing line to the first fluid circuit.
Numbered clause 25: A cryogenic cooling system according to clause 24, wherein the refrigerator assembly further comprises a mixing chamber of a dilution refrigerator, the mixing chamber arranged to receive the helium from the condensing line.
Numbered clause 26: A cryogenic cooling system according to clauses 24 or 25, wherein the second heat exchanger assembly is arranged to receive a flow of supercritical helium from an outlet of a said heat exchanger of the first set of heat exchangers.
Numbered clause 27: A cryogenic cooling system according to any of clauses 22 to 26, wherein the refrigerator assembly comprises a plurality of dilution refrigerators, and wherein the system further comprises a plurality of modules, each said module comprising a module housing, the module housing having a plurality of side faces, wherein two or more said modules are mutually connected at respective side faces, wherein each said dilution refrigerator is arranged within a respective said module, and wherein the connected modules form the vacuum chamber.
Numbered clause 28: A cryogenic cooling system according to any of the preceding clauses, wherein the one or more heat exchangers of the first heat exchanger assembly are formed by additive manufacturing.
Numbered clause 29: A quantum information processing system comprising a cryogenic cooling system according to any of the preceding clauses.

## Claims

1. A cryogenic cooling system comprising:
a vacuum chamber, the vacuum chamber comprising: a target assembly and a first heat exchanger assembly, the first heat exchanger assembly comprising one or more heat exchangers thermally coupled to the target assembly, wherein each said heat exchanger of the first heat exchanger assembly comprises an inlet (204) and an outlet (206);
a helium refrigeration plant fluidly coupled to the first heat exchanger assembly for supplying helium to the inlet (204) of each said heat exchanger of the first heat exchanger assembly in a supercritical fluid state;
wherein each said heat exchanger of the first heat exchanger assembly is configured to convey the helium from the inlet (204) to the outlet (206) in the supercritical fluid state;
wherein each said heat exchanger of the first heat exchanger assembly comprises a stack of plates (208), wherein the plates are profiled to form channels (212) between each adjacent plate, the channels (212) for conveying the helium between the inlet (204) and the outlet (206).

2. A cryogenic cooling system according to claim 1, wherein each said heat exchanger of the first heat exchanger assembly comprises a housing (202) in which the stack of plates (208) is arranged, wherein the housing (202) is mounted to the target assembly (11-14).

3. A cryogenic cooling system according to claim 2, wherein each said heat exchanger (200) of the first heat exchanger assembly comprises a plurality of through-holes (210, 220), each said through-hole extending through the stack of plates (208) and through opposing sides of the housing (202), wherein each said through-hole (210, 220) is fluidly decoupled from the channels (212) and configured to receive a respective fastening member.

4. A cryogenic cooling system according to claim 3, further comprising one or more said fastening members arranged within the through-holes (210, 220) and configured to increase the contact force between the housing (202) and the target assembly (11-14).

5. A cryogenic cooling system according to claims 3 or 4, wherein one or more of the through-holes (220) is arranged between two or more said channels (212).

6. A cryogenic cooling system according to any of claims 3 to 5, wherein the through-holes (220) comprise one or more arrays of through-holes, each said array comprising a plurality of said through-holes which are linearly arranged in a first direction along the surface of the plates, wherein the channels (212) are profiled to convey the helium between the inlet (204) and the outlet (206) in the first direction, wherein the stack of plates (208) comprises one or more array portions (216) and two or more channel portions (214), each said array portion (216) being arranged between two said channel portions (214), wherein each said array of through-holes (220) is arranged within a respective said array portion (216), and wherein the channels (212) are arranged within the channel portions (214).

7. A cryogenic cooling system according to claim 6, wherein the channels (212") are further arranged within the array portion(s) (216") for conveying the helium along one or more subareas of the plates that are positioned between adjacent through-holes of a said array (220").

8. A cryogenic cooling system according to claim 7, wherein the stack of plates (208) comprises one or more flow balancing features (218") arranged within each said subarea for controlling the flow of the helium across the array portion(s) (216").

9. A cryogenic cooling system according to claims 7 or 8, wherein channels (212") are arranged so that the flow impedance across the array portion(s) (216") is substantially equal to the flow impedance of the flow across the channel portions (214").

10. A cryogenic cooling system according to any of the preceding claims wherein each said heat exchanger (200) of the first heat exchanger assembly is a printed circuit heat exchanger.

11. A cryogenic cooling system according to any of the preceding claims, wherein each plate in the stack of plates (208) comprises an inlet region (231a, 231b), an outlet region (232a, 232b), and a central region (230a, 230b) arranged between the inlet region (231a, 231b) and the outlet region (232a, 232b), wherein the channels (212) are arranged across the central region (230a, 230b), wherein the inlet region (231a, 231b) is arranged to covey the helium from the inlet (204) to the channels (212), and wherein the outlet region (232a, 232b) is arranged to convey the helium from the channels (212) to the outlet (206), wherein the inlet region (231a, 231b) and the outlet region (232a, 232b) each comprise one or more apertures (225-228) to convey the helium in a direction normal to the plane of the plates.

12. A cryogenic cooling system according to claim 11, wherein the stack of plates comprises a first series of plates (222) and a second series of plates (224), wherein two or more plates of the first series (222) are arranged between each said plate of the second series (224), wherein a said aperture formed on the inlet region (231a) of each plate of the first series (222) is aligned with a said aperture formed on the inlet region (231a) of an adjacent plate of the first series to form an inlet conduit (225) for conveying the helium along the inlet region (231a) and to respective ingress points for each of a plurality of the channels (212).

13. A cryogenic cooling system according to claim 12, wherein the plates of the first series (222) are further arranged so that a said aperture formed on the outlet region (232a) of each plate of the first series (222) is aligned with a said aperture formed on the outlet region (232a) of an adjacent plate of the first series (222) to form an outlet conduit (226) for conveying the helium from respective egress points for each of a plurality of the channels (212) and along the outlet region (232a), wherein the inlet conduit (225) and the outlet conduit (226) extend substantially along the width of the central region (230a).

14. A cryogenic cooling system according to claim 13, wherein the inlet region (231b) of each plate of the second series (224) comprises a plurality of apertures (217) that overlap the inlet conduit (225), and wherein the outlet region (232b) of each plate of the second series (224) comprises a plurality of apertures (228) that overlap the outlet conduit (226).

15. A cryogenic cooling system according to claim 14, wherein the shape or size of each aperture (227') of the second series sequentially changes along the respective inlet region (231b') and outlet region in which the apertures (227') are arranged.

16. A cryogenic cooling system according to any of claims 12 to 15, wherein the inlet (204') comprises an inlet orifice extending into the heat exchanger, wherein one or more plates of the second series (224') abut the inlet orifice, wherein each aperture (225-228) of the inlet region (231a, 231b) and the outlet region (232a, 232b) is preferably aligned along an axis of the inlet (204) and the outlet (206) respectively, wherein said axes extend along the plane of the plates.

17. A cryogenic cooling system according to any of the preceding claims, further comprising a refrigerator assembly, the refrigerator assembly comprising a plurality of thermal stages (11-14), each said thermal stage having a respective base temperature in use that is above 2.0 K, wherein the target assembly comprises one or more of the thermal stages (11-14), wherein the first heat exchanger assembly comprises a plurality of said heat exchangers (200), each said heat exchanger (200) of the first heat exchanger assembly being mounted to a respective said thermal stage (11-14).

18. A cryogenic cooling system according to claim 17, further comprising a first fluid circuit (240) and a second fluid circuit (242), wherein the first heat exchanger assembly comprises a first set of heat exchangers and a second set of heat exchangers, each said set comprising one or more said heat exchangers (200), wherein the first set of heat exchangers forms part of the first fluid circuit (240) and the second set of heat exchangers forms part of the second fluid circuit (242), wherein the first set of heat exchangers is mounted to a first thermal stage (11) having a base temperature between 2 and 4 K, and wherein the second set of heat exchangers is mounted to one or more thermal stages (12-14) having a base temperature above that of the first thermal stage (11), wherein the refrigerator assembly further comprises a condensing line (250) for supplying helium, the system further comprising a second heat exchanger assembly comprising one or more heat exchangers (252) arranged to thermally couple the condensing line (250) to the first fluid circuit (240).
